# EUROPEAN PATENT SPECIFICATION

(11) **EP 2 876 557 B1**
(45) Date of publication and mention of the grant of the patent: **01.06.2016**
(21) Application number: 13306599.5
(22) Date of filing: 22.11.2013
(51) Int. Cl.: G06F 11/10

(54) **Detecting a read access to unallocated or uninitialized memory**
Erkennung eines Lesezugriffs auf nicht zugewiesenen oder nicht initialisierten Speicher
Détection d'un accès de lecture pour mémoire non initialisée ou non attribuée

(43) Date of publication of application: 27.05.2015
(73) Proprietor: ALCATEL LUCENT, 92100 Boulogne-Billancourt (FR)
(72) Inventor: Von Gemuenden, Detlef, 90411 Nuernberg (DE)
(74) Representative: ALU Antw Patent Attorneys

(56) References cited:
- GB-A- 2 455 212
- JP-A- H06 214 814

## Description

### FIELD OF THE INVENTION

The present invention relates to the field of memory management. In particular, the present invention relates to a method and a device for detecting a read access to unallocated or uninitialized memory.

### BACKGROUND

Memory management relates to the allocation of computer memory to computer programs. The operating system allocates memory to computer programs according to their needs and memory availability.

Commonly used programming languages such as C and C++ require that the software developer cares about memory allocation and memory initialization. Software bugs related to the use of unallocated or uninitialized memory, for example reading from memory which has been freed, are hard to spot and may result in unpredictable misbehavior of the software system. Thus, various solutions have been proposed for detecting access to unallocated or uninitialized memory: Static code checker, runtime software and use of a hardware CPU emulator.

However, static code checker cannot always detect an access to uninitialized memory and can hardly detect the usage of released memory area. Runtime software can better detect such failure, but at the cost of runtime penalties. Finally, hardware CPU emulators are very expensive, rarely available, complex to use, and alter the execution speed of the software system.

GB 2 455 212 describes the use of an error correction code for error detection in processor status register files. JP06214814 describes the use of parity bits for detecting illegal read access to the unused memory area of a storage device.

### SUMMARY

It is thus an object of embodiments of the present invention, which is defined in detail in the appended independent claims 1 and 4, to propose a method and a device for detecting a read access to unallocated or uninitialized memory, which do not show the inherent shortcomings of the prior art.

Accordingly, embodiments relate to a data processing device for detecting a read access to unallocated or uninitialized memory, comprising a processor, a memory controller and a memory, wherein the processor is configured for executing an operating system and computer programs, wherein the operating system is configured for allocating and releasing memory for said computer programs,
wherein the memory controller comprises an error correction code determination unit, and is configured for:
- in response to a write access command for storing first data in the memory, determining a first error correction code in function of said first data and storing said first error correction code and said first data in association in said memory,
- in response to a read access command for reading second data from the memory, determining a second error correction code in function of the second data, comparing the second error correction code with a third error correction code stored in association with said second data in the memory, and outputting the second data if the second and third error correction codes match or outputting an read error signal if the second and third error correction codes do not match,
- in response to a write access command to a test interface of the memory controller, storing a fourth error correction code in association with third data in the memory, wherein the fourth error correction code is invalid with respect to said third data,
wherein the processor is configured for outputting a write access command for a memory area to said test interface of the memory controller in response to releasing of the memory area by the operating system.

Correspondingly, embodiments relate to a method for detecting a read access to unallocated or uninitialized memory, executed by a data processing device comprising a processor, a memory controller and a memory, comprising:
- executing, by the processor, an operating system and computer programs, wherein the operating system is configured for allocating and releasing memory for said computer programs,
- in response to a write access command for storing first data in the memory, the memory controller determines a first error correction code in function of said first data and stores said first error correction code and said first data in association in said memory,
- in response to a read access command for reading second data from the memory, the memory controller determines a second error correction code in function of the second data, compares the second error correction code with a third error correction code stored in association with said second data in the memory, and outputs the second data if the second and third error correction codes match or outputs an read error signal if the second and third error correction codes do not match,

- in response to a write access command to a test interface of the memory controller, the memory controller stores a fourth error correction code in association with third data in the memory, wherein the fourth error correction code is invalid with respect to said third data,
- in response to releasing of a memory area by the operating system, outputting, by the processor, a write access command for the released memory area to said test interface of the memory controller.

The processor may be configured for outputting a write access command to said test interface of the memory controller during an initialization process of the operating system.

The processor may be configured for identifying a piece of software which has accessed unallocated or uninitialized memory, in response to said read error signal.

### BRIEF DESCRIPTION OF THE DRAWINGS

The above and other objects and features of the invention will become more apparent and the invention itself will be best understood by referring to the following description of embodiments taken in conjunction with the accompanying drawings wherein:
Figure 1 is a functional view of a data processing device for detecting a read access to unallocated or uninitialized memory, and
Figures 2 to 4 are flow diagrams showing the functioning of the data processing device of figure 1.

### DESCRIPTION OF EMBODIMENTS

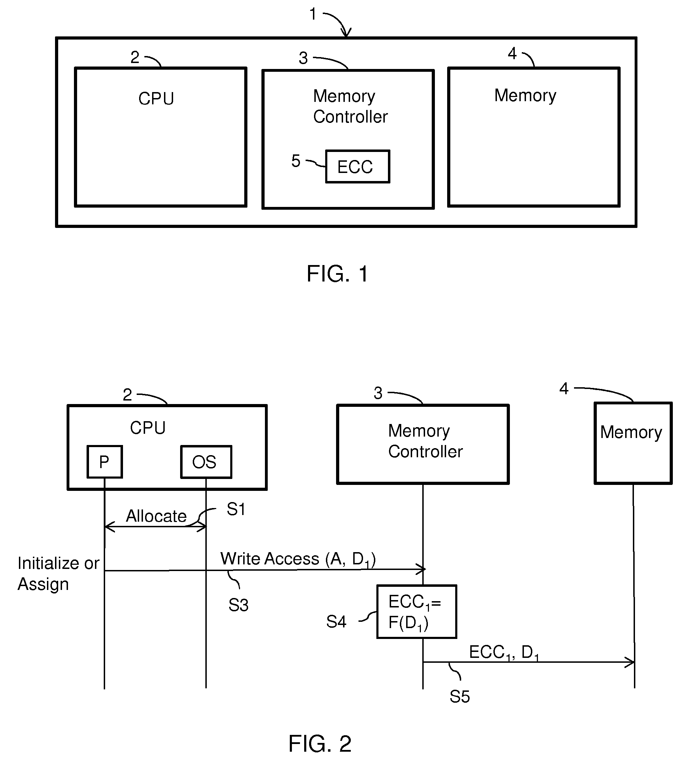

**Figure 1** shows a data processing device 1 comprising a processor 2, a memory controller 3 and a memory 4.

The processor 2 is configured for executing an operating system OS and computer programs P. The operating system OS is a collection of computer programs (i.e. instructions executable by the processor 2) and data that manages computer hardware resources of the data processing device 1 and provides common services for the computer programs P. The tasks of the operating system OS include memory management, that is allocating and releasing memory for the computer programs P.

A computer program P comprises instructions executable by the processor 2 for performing determined operations. Execution of a computer program P may comprise interacting with the operating system OS for allocating memory and releasing memory. Execution of a computer program P may also comprise storing data in the memory 4 and reading data from the memory 4.

The memory controller 3 comprises an error correction code determination unit 5 and is in charge of processing the write access and read access commands from the processor 2. The error correction code determination unit 5 is capable of determining an error correction code in function of data stored or to be stored in the memory 4. The skilled person is familiar with different techniques for determining an error correction code and this will not be described in detail. The functioning of the memory controller 3 will be described in more detail with reference to figures 2 to 4.

The memory 4 is a data storing device. In this embodiment, the memory 4 is a RAM. However, in other embodiments, the memory 4 may be a hard disk, a flash memory...

The processor 2, the memory controller 3 and the memory 4 may be included in ICs connected by busses (for example a data bus, an address bus...). For example, each of the processor 2, the memory controller 3 and the memory 4 may correspond to distinct ICs. In another example, the memory controller 3 may be included in the same IC as the memory 4 or the processor 2.

**Figure 2** is a flow diagram illustrating the storing of data in the memory 4 by a computer program P.

During the execution of the computer program P by the processor 2, memory is allocated by the operating system OS for the computer program P (Step S1). For example, memory is allocated at start-up of the computer program P or upon request of the computer program P. Various techniques exist for memory allocation.

Later, the computer program P needs to store data D₁. For example, the computer program P initialize a variable or reassign a new value to an already assigned variable. Accordingly, the computer program P sends a write access command to the memory controller 3 (Step S3). The write access command comprises for example an address A and data D₁ to be stored in the memory 4. The address A corresponds to a part of the memory 4 which has been allocated for the computer program P.

In response to the write access command, the memory controller 3 determines an error correction code ECC₁ in function of the data D₁ (step S4), and stores the error correction code ECC₁ and the data D₁ in association in the memory 4. Storing an error correction code and data in association in the memory 4 may be performed in various manners. For example, the memory 4 comprises an ECC-part and a data-part, wherein respective memory blocks of the ECC-part correspond to associated memory blocks of the data-part.

Accordingly, data stored in allocated and initialized memory is stored in association with a valid error correction code.

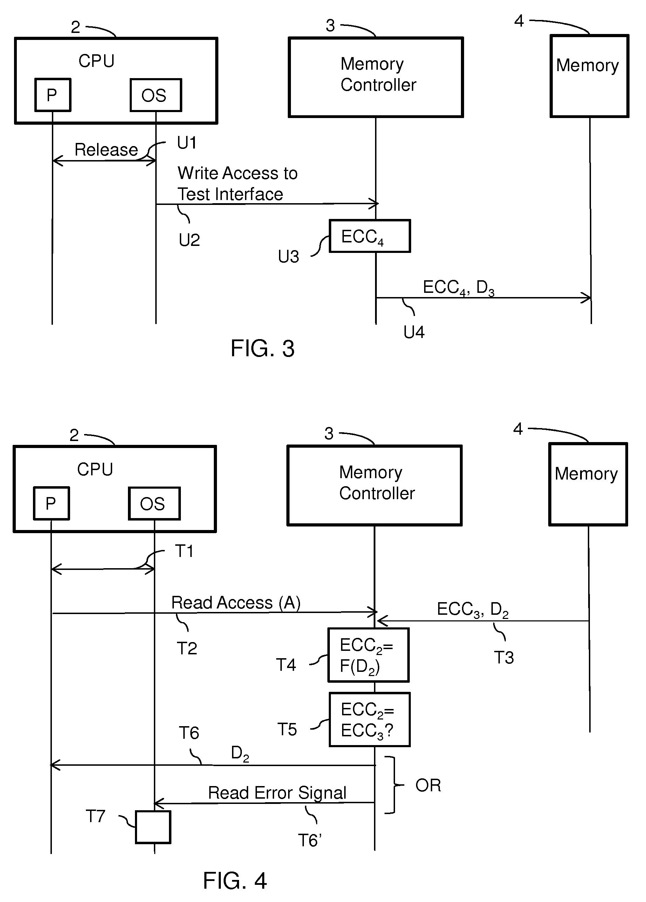

**Figure 3** is a flow diagram illustrating the storing of invalid error correction codes in the memory 4.

During the execution of the computer program P by the processor 2, memory allocated to the computer program P may be released by the operating system OS (Step U1). For example, memory is released when the computer program P exits or upon request of the computer program P.

In response to the release of memory, the operating system OS sends a write access command to the memory controller 3 (Step U2). The write access command comprises an address A. However, the write access command of step U2 is different than the write access command of step S3 described above: the write access command of step U2 is directed to a test interface of the memory controller 3.

In response to the write access command to its test interface, the memory controller 3 determines an invalid error correction code ECC₄ (Step U3), and stores the invalid error correction code ECC₃ and data D₃ in association in the memory 4. An invalid error correction code means that the error correction code ECC₃ is different than the error correction code that the error correction code determination unit 5 would determine in function of the data D₃.

Accordingly, the released memory area comprises an invalid error correction code.

Similarly, as part of an initialization process, for example at start-up of the operating system OS, the operating system OS sends a write access command to the test interface of the memory controller 3 (not shown). Accordingly, in its initial state after start-up of the operating system OS, the non-allocated parts of the memory 4 comprise an invalid error correction code.

In other words, unallocated or uninitialized memory comprises an invalid error correction code.

An invalid error correction code may be determined for example by determining valid error correction code and then inverting at least one predetermined bit.

**Figure 4** is a flow diagram illustrating the reading of data from the memory 4 by a computer program P.

During execution of the computer program P, the computer program P may need to use data D₂ stored in the memory 4 (Step T1). Accordingly, the computer program P sends a read access command to the memory controller 3 (Step T2). The read access command comprises for example an address A.

In response to the read access command, the memory controller 3 obtains the data D₂ stored in the memory 4 at address A (step T3), and determines an error correction code ECC₂ in function of the data D₂ (step T4). Then, the memory controller 3 compares the determined error correction code ECC₂ with the error correction code ECC₃ stored in association with the data D₂ in the memory 4. (Step T5).

In case the error correction code ECC₂ and the error correction code ECC₃ match (i.e. are equal), the memory controller 3 outputs the data D₂ (step T6), which may then be used by the computer program P.

In contrast, if the error correction code ECC₂ and the error correction code ECC₃ do not match (i.e. are not equal), the memory controller 3 outputs a read error signal to the operating system (step T6').

As explained before, data stored in allocated and initialized memory is stored in association with a valid error correction code. In contrast, unallocated or uninitialized memory comprises an invalid error correction code. Accordingly, the read error signal is a sign of a read access to unallocated or uninitialized memory. The read access to unallocated or uninitialized memory has been detected. Thus, in response to the read error signal, the operating system OS identifies the piece of software which has illegally accessed the unallocated or uninitialized memory (step T7). Identification may be based for example on Stack-Trace-Back and Process-Info, which allow a programmer to investigate.

It should be noted that the functioning of the memory controller 3 is that of a normal ECC-enabled memory controller comprising a test interface. Accordingly, the detection of a read access to unallocated or uninitialized memory in the data processing device 1 comes at no additional hardware cost. Furthermore, the impact on the runtime of the system is limited: the processor 2 (the operating system OS) is configured for sending write access commands to the test interface of the memory controller 3 in response to releasing of memory or during an initialization process, but this does not involve speed penalties on the computer programs P.

It is to be remarked that the functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared, for example in a cloud computing architecture. Moreover, explicit use of the term "processor" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Their function may be carried out through the operation of program logic, through dedicated logic, through the interaction of program control and dedicated logic, or even manually, the particular technique being selectable by the implementer as more specifically understood from the context.

It should be further appreciated by those skilled in the art that any block diagrams herein represent conceptual views of illustrative circuitry embodying the principles of the invention. Similarly, it will be appreciated that any flow charts represents various processes which may be substantially represented in computer readable medium and so executed by a computer or processor, whether or not such computer or processor is explicitly shown.

Embodiments of the method can be performed by means of dedicated hardware and/of software or any combination of both.

While the principles of the invention have been described above in connection with specific embodiments, it is to be clearly understood that this description is made only by way of example and not as a limitation on the scope of the invention, as defined in the appended claims.

## Claims

1. Data processing device (1) for detecting a read access to unallocated or uninitialized memory, comprising a processor (2), a memory controller (3) and a memory (4),
wherein the processor (2) is configured for executing an operating system (OS) and computer programs (P), wherein the operating system (OS) is configured for allocating and releasing memory for said computer programs (P),
wherein the memory controller (3) comprises an error correction code determination unit (5), and is configured for:
- in response to a write access command for storing first data (D₁) in the memory (4), determining a first error correction code (ECC₁) in function of said first data (D₁) and storing said first error correction code (ECC₁) and said first data (D₁) in association in said memory (4),
- in response to a read access command for reading second data (D₂) from the memory, determining (T4) a second error correction code (ECC₂) in function of the second data (D₂), comparing (T5) the second error correction code (ECC₂) with a third error correction code (ECC₃) stored in association with said second data (D₂) in the memory (4), and outputting (T6) the second data (D₂) if the second and third error correction codes match or outputting (T6') an read error signal if the second and third error correction codes do not match,
- in response to a write access command to a test interface of the memory controller (3), storing (U4) a fourth error correction code (ECC₄) in association with third data (D₃) in the memory (4), wherein the fourth error correction code (ECC₄) is invalid with respect to said third data (D₃),
wherein the processor is configured for outputting (U2) a write access command for a memory area to said test interface of the memory controller (3) in response to releasing (U1) of the memory area by the operating system (OS).

2. Data processing device according to claim 1, wherein the processor (2) is configured for outputting a write access command to said test interface of the memory controller (3) during an initialization process of the operating system (OS).

3. Data processing device according to claim 1 or 2, wherein the processor (2) is configured for identifying (T7) a piece of software which has accessed unallocated or uninitialized memory, in response to said read error signal.

4. Method for detecting a read access to unallocated or uninitialized memory, executed by a data processing device (1) comprising a processor (2), a memory controller (3) and a memory (4), comprising:
- executing, by the processor (2), an operating system (OS) and computer programs (P), wherein the operating system is configured for allocating and releasing memory for said computer programs,
- in response to a write access command for storing first data in the memory, the memory controller determines (S4) a first error correction code in function of said first data and stores (S5) said first error correction code and said first data in association in said memory,
- in response to a read access command for reading second data from the memory, the memory controller determines (T4) a second error correction code in function of the second data, compares (T5) the second error correction code with a third error correction code stored in association with said second data in the memory, and outputs (T6) the second data if the second and third error correction codes match or outputs (T6') an read error signal if the second and third error correction codes do not match,
- in response to a write access command to a test interface of the memory controller, the memory controller stores (U4) a fourth error correction code in association with third data in the memory, wherein the fourth error correction code is invalid with respect to said third data,
- in response to releasing (U1) of a memory area by the operating system, outputting (U2), by the processor, a write access command for the released memory area to said test interface of the memory controller.

5. Method according to claim 4, comprising outputting, by the processor, a write access command to said test interface of the memory controller during an initialization process of the operating system.

6. Method according to claim 4 or 5, comprising identifying (T7), by the processor, a piece of software which has accessed unallocated or uninitialized memory, in response to said read error signal.

## Patentansprüche

1. Datenverarbeitungsvorrichtung (1) zum Erkennen eines Lesezugriffs auf einen nicht zugewiesenen oder nicht initialisierten Speicher, umfassend einen Prozessor (2), einen Speichercontroller (3) und einen Speicher (4),
wobei der Prozessor (2) zum Ausführen eines Betriebssystems (OS) und von Computerprogrammen (P) ausgelegt ist, wobei das Betriebssystem (OS) zum Zuweisen und Freigeben von Speicher für besagte Computerprogramme (P) ausgelegt ist,
wobei der Speichercontroller (3) eine Fehlerkorrekturcode-Bestimmungseinheit (5) umfasst und ausgelegt ist zum:
- in Antwort auf einen Schreibzugriffsbefehl zum Speichern von ersten Daten (D₁) im Speicher (4), Bestimmen eines ersten Fehlerkorrekturcodes (ECC₁) in Abhängigkeit von besagten ersten Daten (D₁) und Speichern des besagten ersten Fehlerkorrekturcodes (ECC₁) und der besagten zugehörigen ersten Daten (D₁) im besagten Speicher (4),
- in Antwort auf einen Lesezugriffsbefehl zum Lesen von zweiten Daten (D₂) vom Speicher, Bestimmen (T4) eines zweiten Fehlerkorrekturcodes (ECC₂) in Abhängigkeit von den zweiten Daten (D₂), Vergleichen (T5) des zweiten Fehlerkorrekturcodes (ECC₂) mit einem dritten Fehlerkorrekturcode (ECC₃), der in Verbindung mit besagten zweiten Daten (D₂) im Speicher (4) gespeichert ist, und Ausgeben (T6) der zweiten Daten (D₂), wenn der zweite und dritte Fehlerkorrekturcode übereinstimmen, oder Ausgeben (T6') eines Lesefehlersignals, wenn der zweite und dritte Fehlerkorrekturcode nicht übereinstimmen,
- in Antwort auf einen Schreibzugriffsbefehl an eine Testschnittstelle des Speichercontrollers (3), Speichern (U4) eines vierten Fehlerkorrekturcodes (ECC₄) in Verbindung mit dritten Daten (D₃) im Speicher (4), wobei der vierte Fehlerkorrekturcode (ECC₄) in Bezug auf besagte dritte Daten (D₃) ungültig ist, wobei der Prozessor aus gelegt ist zum Ausgeben (U2) eines Schreibzugriffsbefehls für einen Speicherbereich an besagte Testschnittstelle des Speichercontrollers (3) in Antwort auf das Freigeben (U1) des Speicherbereichs durch das Betriebssystem (OS).

2. Datenverarbeitungsvorrichtung nach Anspruch 1, wobei der Prozessor (2) ausgelegt ist zum Ausgeben eines Schreibzugriffsbefehls an besagte Testschnittstelle des Speichercontrollers (3) während eines Initialisierungsprozesses des Betriebssystems (OS).

3. Datenverarbeitungsvorrichtung nach Anspruch 1 oder 2, wobei der Prozessor (2) ausgelegt ist zum Identifizieren (T7) eines Softwareteils, der auf einen nicht zugewiesenen oder nicht initialisierten Speicher zugegriffen hat, in Antwort auf das besagte Lesefehlersignal.

4. Verfahren zum Erkennen eines Lesezugriffs auf einen nicht zugewiesenen oder nicht initialisierten Speicher, ausgeführt durch eine Datenverarbeitungsvorrichtung (1), umfassend einen Prozessor (2), einen Speichercontroller (3) und einen Speicher (4), umfassend:
- Ausführen, durch den Prozessor (2), eines Betriebssystems (OS) und von Computerprogrammen (P), wobei das Betriebssystem zum Zuweisen und Freigeben von Speicher für besagte Computerprogramme ausgelegt ist,
- in Antwort auf einen Schreibzugriffsbefehl zum Speichern von ersten Daten im Speicher, Bestimmen (S4) eines ersten Fehlerkorrekturcodes in Abhängigkeit von besagten ersten Daten und Speichern (S5) des besagten ersten Fehlerkorrekturcodes und der besagten zugehörigen ersten Daten im besagten Speicher durch den Speichercontroller,
- in Antwort auf einen Lesezugriffsbefehl zum Lesen von zweiten Daten vom Speicher, Bestimmen (T4) eines zweiten Fehlerkorrekturcodes in Abhängigkeit von den zweiten Daten, Vergleichen (T5) des zweiten Fehlerkorrekturcodes mit einem dritten Fehlerkorrekturcode, der in Verbindung mit besagten zweiten Daten im Speicher gespeichert ist, und Ausgeben (T6) der zweiten Daten, wenn der zweite und dritte Fehlerkorrekturcode übereinstimmen, oder Ausgeben (T6') eines Lesefehlersignals, wenn der zweite und dritte Fehlerkorrekturcode nicht übereinstimmen, durch den Speichercontroller,
- in Antwort auf einen Schreibzugriffsbefehl an eine Testschnittstelle des Speichercontrollers, Speichern (U4) eines vierten Fehlerkorrekturcodes in Verbindung mit dritten Daten im Speicher durch den Speichercontroller, wobei der vierte Fehlerkorrekturcode in Bezug auf besagte dritte Daten ungültig ist,
- in Antwort auf das Freigeben (U1) eines Speicherbereichs durch das Betriebssystem, Ausgeben (U2), durch den Prozessor, eines Schreibzugriffsbefehls für den freigegebenen Speicherbereich an besagte Testschnittstelle des Speichercontrollers.

5. Verfahren nach Anspruch 4, umfassend das Ausgeben, durch den Prozessor, eines Schreibzugriffsbefehls an besagte Testschnittstelle des Speichercontrollers während eines Initialisierungsprozesses des Betriebssystems.

6. Verfahren nach Anspruch 4 oder 5, umfassend das Identifizieren (T7), durch den Prozessor, eines Softwareteils, der auf einen nicht zugewiesenen oder nicht initialisierten Speicher zugegriffen hat, in Antwort auf das besagte Lesefehlersignal.

## Revendications

1. Dispositif de traitement de données (1) pour détecter un accès en lecture à une mémoire non allouée ou non initialisée, comprenant un processeur (2), un contrôleur de mémoire (3) et une mémoire (4),
le processeur (2) étant configuré pour exécuter un système d'exploitation (OS) et des programmes informatiques (P), le système d'exploitation (OS) étant configuré pour allouer et libérer la mémoire pour lesdits programmes informatiques (P),
le contrôleur de mémoire (3) comprenant une unité de détermination de code de correction d'erreur (5) et étant configuré pour :
- en réponse à une commande d'accès en écriture pour stocker des premières données (D₁) dans la mémoire (4), déterminer un premier code de correction d'erreur (ECC₁) en fonction desdites premières données (D₁) et stocker ledit premier code de correction d'erreur (ECC₁) et lesdites premières données (D1) en association dans ladite mémoire (4),
- en réponse à une commande d'accès en lecture pour lire des deuxièmes données (D₂) à partir de la mémoire, déterminer (T4) un deuxième code de correction d'erreur (ECC₂) en fonction des deuxièmes données (D2), comparer (T5) le deuxième code de correction d'erreur (ECC₂) à un troisième code de correction d'erreur (ECC₃) stocké en association avec lesdites deuxièmes données (D₂) dans la mémoire (4), et délivrer en sortie (T6) les deuxièmes données (D₂) si le deuxième et le troisième codes de correction d'erreur correspondent ou délivrer en sortie (T6') un signal d'erreur de lecture si le deuxième et le troisième codes de correction d'erreur ne correspondent pas,
- en réponse à une commande d'accès en écriture sur une interface de test du contrôleur de mémoire (3), stocker (U4) un quatrième code de correction d'erreur (ECC₄) en association avec des troisièmes données (D₃) dans la mémoire (4), le quatrième code de correction d'erreur (ECC₄) étant invalide par rapport auxdites troisièmes données (D₃), dans lequel le processeur est configuré pour délivrer en sortie (U2) une commande d'accès en écriture pour une zone de mémoire à ladite interface de test du contrôleur de mémoire (3) en réponse à la libération (U1) de la zone de mémoire par le système d'exploitation (OS).

2. Dispositif de traitement de données selon la revendication 1, dans lequel le processeur (2) est configuré pour délivrer en sortie une commande d'accès en écriture à ladite interface de test du contrôleur de mémoire (3) durant un processus d'initialisation du système d'exploitation (OS).

3. Dispositif de traitement de données selon la revendication 1 ou 2, dans lequel le processeur (2) est configuré pour identifier (T7) un logiciel qui a accédé à une mémoire non allouée ou non initialisée, en réponse audit signal d'erreur de lecture.

4. Procédé de détection d'un accès en lecture à une mémoire non allouée ou non initialisée, exécutée par un dispositif de traitement de données (1) comprenant un processeur (2), un contrôleur de mémoire (3) et une mémoire (4), comprenant les étapes suivantes :
- exécuter, au moyen du processeur (2), un système d'exploitation (OS) et des programmes informatiques (P), le système d'exploitation étant configuré pour allouer et libérer la mémoire pour lesdits programmes informatiques,
- en réponse à une commande d'accès en écriture pour stocker des premières données dans la mémoire, le contrôleur de mémoire détermine (S4) un premier code de correction d'erreur en fonction desdites premières données et stocke (S5) ledit premier code de correction d'erreur et lesdites premières données en association dans ladite mémoire,
- en réponse à une commande d'accès en lecture pour lire des deuxièmes données à partir de la mémoire, le contrôleur de mémoire détermine (T4) un deuxième code de correction d'erreur en fonction des deuxièmes données, compare (T5) le deuxième code de correction d'erreur à un troisième code de correction d'erreur stocké en association avec lesdites deuxièmes données dans la mémoire, et délivre en sortie (T6) les deuxièmes données si le deuxième et le troisième codes de correction d'erreur correspondent ou délivre en sortie (T6') un signal d'erreur de lecture si le deuxième et le troisième codes de correction d'erreur ne correspondent pas,
- en réponse à une commande d'accès en écriture sur une interface de test du contrôleur de mémoire, le contrôleur de mémoire stocke (U4) un quatrième code de correction d'erreur en association avec des troisièmes données dans la mémoire, le quatrième code de correction d'erreur étant invalide par rapport auxdites troisièmes données,
- en réponse à la libération (U1) d'une zone de mémoire par le système d'exploitation, délivrer en sortie (U2), au moyen du processeur, une commande d'accès en écriture pour la zone de mémoire libérée à ladite interface de test du contrôleur de mémoire.

5. Procédé selon la revendication 4, consistant à délivrer en sortie, au moyen du processeur, une commande d'accès en écriture à ladite interface de test du contrôleur de mémoire durant un processus d'initialisation du système d'exploitation.

6. Procédé selon la revendication 4 ou 5, comprenant l'identification (T7), au moyen du processeur, d'un logiciel qui a accédé à une mémoire non allouée ou non initialisée, en réponse audit signal d'erreur de lecture.
